# DEMANDE DE BREVET EUROPEEN

(11) **EP 0 962 985 A1**
(43) Date de publication de la demande: **08.12.1999**
(21) Numéro de dépôt: 99401339.9
(22) Date de dépôt: 03.06.1999
(51) Int. Cl.: H01L 29/10, H01L 29/737, H01L 21/331

(54) **Transistor bipolaire vertical comportant une base extrinsèque de rugosité réduite, et procédé de fabrication**

(30) Priorité: 05.06.1998 FR 9807061
(71) Demandeur: STMicroelectronics S.A., 94250 Gentilly (FR); COMMISSARIAT A L'ENERGIE ATOMIQUE, 75015 Paris (FR); FRANCE TELECOM, 75015 Paris (FR)
(72) Inventeur: Marty, Michel, 38760 St. Paul de Varces (FR); Chantre, Alain, 38180 Seyssins (FR); Regolini, Jorge, 38190 Bernin (FR)
(74) Mandataire: Casalonga, Axel

(57) **Abrégé**

Le transistor bipolaire vertical comprend une base à hétérojonction SiGe formée d'un empilement (8) de couches de silicium et de silicium-germanium reposant sur une couche initiale (17) de nitrure de silicium s'étendant sur une région d'isolement latéral (5) entourant la partie supérieure du collecteur intrinsèque (4), ainsi que sur la surface du collecteur intrinsèque (4) située à l'intérieur d'une fenêtre ménagée dans la couche initiale de nitrure de silicium (17).

## Description

L'invention concerne les transistors bipolaires verticaux, notamment ceux destinés à s'intégrer dans les technologies haute fréquence et à très haut degré d'intégration (technologie VLSI : "Very Large Scale Integration" en langue anglaise), et en particulier les caractéristiques et la réalisation des bases épitaxiées de ces transistors.

L'invention vise notamment à diminuer la rugosité de la base extrinsèque de ces transistors, ainsi que la résistance d'accès à la base.

Dans une autre demande de brevet déposée par le demandeur le même jour que la présente demande de brevet, et ayant pour titre "Transistor bipolaire vertical à faible bruit et procédé de fabrication correspondant", il a été décrit un procédé de réalisation d'un transistor bipolaire vertical à base à hétérojonction silicium-germanium et émetteur épitaxié sur la surface supérieure de cette base.

Tel que décrit dans cette autre demande de brevet, la réalisation de la base comporte une épitaxie non sélective d'un empilement de couches de silicium et de silicium-germanium dans une fenêtre, dite "fenêtre de base", ménagée sur la surface du collecteur intrinsèque, ainsi que sur les deux parties d'une couche de protection de silicium amorphe disposées de part et d'autre de la fenêtre de base.

Avant de procéder à cette épitaxie non sélective, on procède à une désoxydation chimique de la fenêtre de base suivie d'un traitement sous hydrogène à une température supérieure à 600°C permettant de désorber les composants résiduels pouvant subsister à l'issue de la désoxydation chimique. Or, lors de ce traitement de désorption, le silicium amorphe se transforme en polysilicium ce qui conduit à l'obtention de grains plus importants. Il en résulte finalement une augmentation de la rugosité de la surface supérieure de l'empilement de couches épitaxiées au sein duquel sera réalisée la base, ce qui peut être gênant dans certaines applications. En effet, une rugosité trop importante peut poser des problèmes d'alignement de la fenêtre émetteur ainsi que pour les phases de photolithographie des couches ultérieures. En outre, un dénivelé trop important entre les pics et les vallées ménagés sur la surface supérieure de la base peut conduire à des inhomogénéités d'implantation de la base extrinsèque ainsi qu'à un siliciure déposé sur la base, plus rugueux, donc plus résistif et conduisant par conséquent à une augmentation de la résistance d'accès à la base.

L'invention propose donc un procédé de réalisation d'une base à hétérojonction SiGe d'un transistor bipolaire vertical, ce procédé comprenant la formation, sur un bloc semiconducteur comportant une région (par exemple épitaxiée ou implantée) de collecteur intrinsèque entouré dans sa partie supérieure par une région d'isolement latéral, d'une couche initiale de nitrure de silicium ménageant une fenêtre (fenêtre de base) au-dessus de la surface du collecteur intrinsèque. La réalisation de la base comporte ensuite une épitaxie non sélective d'un empilement de couches de silicium et de silicium-germanium sur la surface du collecteur située dans ladite fenêtre et sur la couche initiale de nitrure de silicium.

En d'autres termes, on remplace ici, la couche de silicium amorphe par une couche de nitrure de silicium et on débute l'épitaxie de la base directement sur le nitrure.

Il en résulte une diminution notable de la rugosité de la surface supérieure de l'empilement de base, se traduisant dans certains cas par une réduction de moitié du dénivelé pics - vallées sur la surface de la base extrinsèque.

Par ailleurs, alors que jusqu'à présent la couche de silicium amorphe avait été notamment utilisée pour présenter un substrat homogène de silicium en début d'épitaxie de façon à obtenir une meilleure homogénéité en épaisseur du dépôt de la base, il a été observé que la couche de nitrure de silicium permettait également d'obtenir une bonne homogénéité en épaisseur de la base au-dessus du collecteur intrinsèque et au-dessus de la couche de nitrure de silicium.

L'invention a également pour objet un transistor bipolaire vertical comprenant une base à hétérojonction silicium-germanium formée dans un empilement de couches de silicium et de silicium-germanium reposant sur une couche initiale de nitrure de silicium s'étendant sur la région d'isolement latéral entourant la partie supérieure du collecteur intrinsèque, ainsi que sur la surface du collecteur intrinsèque située à l'intérieur d'une fenêtre ménagée dans la couche initiale de nitrure de silicium.

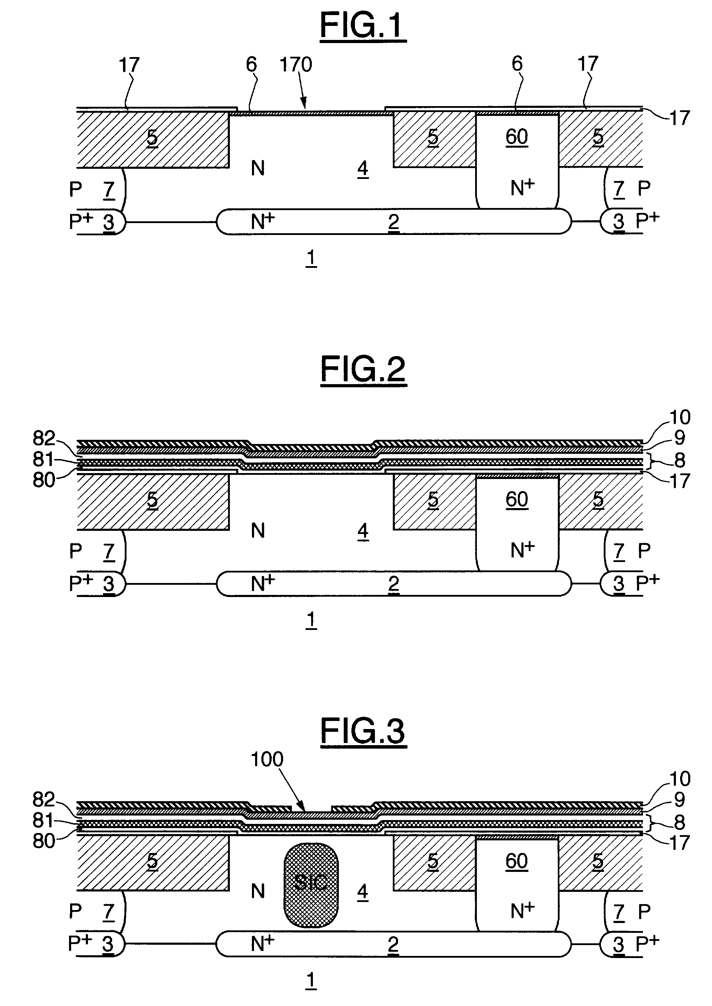

D'autres avantages et caractéristiques de l'invention appraîtront à l'examen de la description détaillée d'un mode de mise en oeuvre et de réalisation nullement limitatif, et des dessins annexés sur lesquels les figures 1 à 6 illustrent schématiquement un mode de mise en oeuvre du procédé selon l'invention aboutissant à un mode de réalisation d'un transistor selon l'invention.

Sur la figure 1, la référence 1 désigne un substrat de silicium, par exemple du type P à la surface duquel on réalise de façon classique et connue en soi une couche enterrée 2 de collecteur extrinsèque, dopée N⁺, par une implantation d'arsenic.

On réalise de même, de façon classique, de part et d'autre du collecteur extrinsèque 2, deux couches enterrées 3, dopées P⁺ à partir d'une implantation de bore.

Sur le substrat 1 ainsi formé, on réalise une épitaxie épaisse, connue en soi, de façon à réaliser une couche 4 de silicium monocristalline de type N ayant une épaisseur typiquement de l'ordre de 1 micron.

On réalise ensuite dans cette couche 4, de façon connue en soi, une région d'isolement latéral 5, soit par un procédé d'oxydation localisée (ou LOCOS), soit du type "tranchée peu profonde" ("Shallow Trench"). On a représenté sur la figure 1, à des fins de simplification, une région d'isolement latéral 5 du type à tranchée peu profonde.

On réalise également de façon classique, notamment par implantation de phosphore, un puits collecteur 60 dopé N⁺ contactant la couche enterrée 2.

On réalise ensuite des implantations de bore de façon à réaliser sous la région d'isolement latéral 5 des caissons 7 dopés P permettant un isolement vis-à-vis des transistors adjacents au transistor bipolaire décrit ici.

On fait croître ensuite, de façon classique, sur la surface du collecteur intrinsèque monocristallin épitaxié 4, un oxyde thermique, typiquement du dioxyde de silicium. Cette croissance de dioxyde de silicium se produit également sur toute la plaquette, et notamment sur le puits collecteur 60. Cet oxyde forme également l'oxyde de grille pour des transistors complémentaires à effet de champ à grilles isolées ( transistors CMOS) réalisés conjointement au transistor bipolaire sur la même plaquette (technologie BiCMOS : Bipolaire-CMOS).

On dépose ensuite sur le bloc semiconducteur ainsi formé une couche 17, formée de nitrure de silicium (Si₃N₄) ayant une épaisseur de l'ordre de 300 Å.

Le dépôt est un dépôt chimique en phase vapeur (dépôt CVD) utilisant un mélange gazeux contenant un précurseur de silicium et un précurseur d'azote.

On grave ensuite, par gravure plasma avec arrêt sur la couche d'oxyde 6, une fenêtre 170 dite "fenêtre de base". Dans le cas où un isolement latéral du type tranchée peu profonde est utilisé, les deux parties de la couche 17 de nitrure de silicium gravée débordent légèrement au-dessus du collecteur intrinsèque 4. Dans le cas où un isolement latéral du type LOCOS est utilisé, la fenêtre 170 de gravure peut être plus large que le collecteur intrinsèque 4.

On procède ensuite (figure 2) à une désoxydation chimique de la couche d'oxyde 6 située au-dessus du collecteur. Il convient de noter ici que l'une des fonctions de la couche de nitrure de silicium 17 est une fonction de protection du reste de la plaquette lors de cette désoxydation chimique et notamment des zones d'isolement latéral lorsque celles-ci sont réalisées par des tranchées peu profondes.

On procède ensuite, après un traitement de désorption de la fenêtre de base sous hydrogène à une température supérieure à 600°C, à une épitaxie d'un empilement 8 de trois couches 80, 81 et 82, au sein desquelles sera réalisée la future base du transistor. Plus précisément, on procède à une épitaxie d'une première couche 80 de silicium non dopée sur une épaisseur de quelques dizaines de nanomètres. La deuxième couche 81 formée de silicium-germanium est ensuite épitaxiée. Elle est en fait composée d'une première sous-couche de Si₁₋ₓGeₓ avec x par exemple constant compris entre 0,1 et 0,2, surmontée d'une deuxième sous-couche formée également d'un alliage de Si₁₋ₓGeₓ (avec x décroissant jusqu'à 0) et dopée P par du bore. L'épaisseur totale de la couche 81 est peu importante, typiquement de 20 à 100 nm.

La deuxième sous-couche de la couche 81 est ensuite surmontée d'une couche épitaxiée 82 de quelques dizaines de nanomètres d'épaisseur de silicium dopé P à partir de bore.

A l'issue de cette épitaxie, réalisée typiquement à 700°C dans un réacteur de dépôt CVD ultrapropre, on obtient donc un empilement de couches monocristallines sur le collecteur intrinsèque dans la fenêtre de base, et polycristallines au-dessus des couches de nitrure de silicium 17. Cet empilement de couches va permettre de former une base à hétérojonction silicium-germanium. Il est à noter ici que l'épitaxie de réalisation de la base à hétérojonction est une épitaxie non sélective.

Outre le fait que cette couche de nitrure de silicium permette également l'obtention d'une bonne homogénéité en épaisseur du dépôt par épitaxie la base, elle permet d'obtenir un dénivelé pic - vallée sur la surface de l'empilement de l'ordre de 500 à 600 Å (alors que ce dénivelé est de l'ordre de 1000 Å avec une couche initiale de silicium amorphe).

On dépose ensuite sur la couche 81 une première couche de dioxyde de silicium ayant une épaisseur de l'ordre de 200 Å. On dépose également sur la première couche de dioxyde de silicium 9, une deuxième couche 10 de nitrure de silicium (Si₃N₄) ayant une épaisseur de 300 Å.

On définit ensuite (figure 3) à l'aide d'un masque une zone 100 dans la couche de nitrure 10 correspondant à une fenêtre émetteur située au-dessus du collecteur intrinsèque 4. On effectue alors de façon classique, à l'aide d'une couche de résine correspondant audit masque, une gravure plasma de la couche de nitrure 10 avec arrêt sur la couche de dioxyde de silicium 9 de façon à dégager la zone 100. On procède ensuite, en conservant la résine présente sur la couche 10 et ayant servi à la gravure de cette dernière, à l'implantation de phosphore, à travers l'empilement. Un surdopage sélectif du collecteur ("selective implantation collector") sous la fenêtre de l'émeteur peut être réalisé en une ou plusieurs implantations contribuant ainsi à augmenter la rapidité du transistor en diminuant la résistance du collecteur. On obtient donc sous la fenêtre émetteur une zone SIC surdopée.

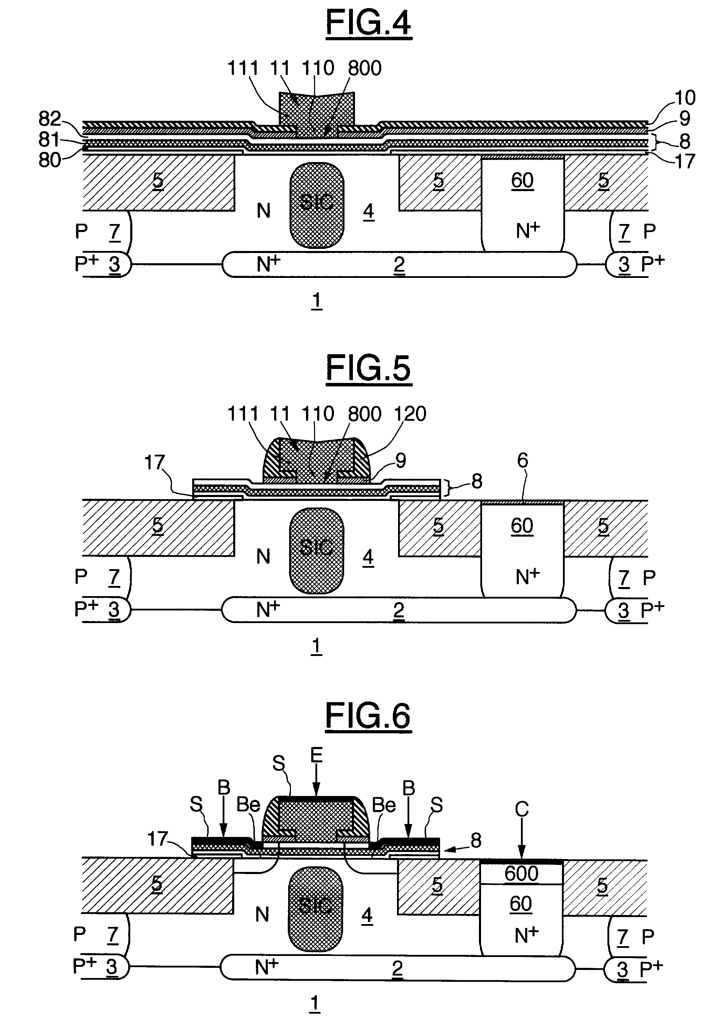

A l'issue de cette étape, on retire la résine présente sur la couche de nitrure de silicium 10 et l'on procède à un traitement chimique de desoxydation de façon à retirer la partie de la couche de dioxyde de silicium 9 située dans la zone 100 et réaliser ainsi la fenêtre émetteur 800 (figure 4).

Un exemple d'un tel traitement chimique de désoxydation consiste à utiliser un bain d'acide à base d'acide fluorhydrique dilué à environ 1% pendant 1 minute, ce qui permet d'obtenir une surface de silicium monocristallin chimiquement propre, c'est-à-dire dont la concentration d'atomes d'oxygène est inférieure à 10¹⁵/cm². Par ailleurs, une telle désoxydation chimique ne dégrade pas la surface de silicium monocristallin sous-jacente (au contraire d'une gravure plasma par exemple) et par conséquent n'introduit pas de défauts cristallins.

Pour parfaire encore l'état de surface du silicium, on effectue avantageusement un traitement de désorption sous hydrogène à haute température (> à 550°C) de façon à évacuer des impuretés résiduelles adsorbées à la surface du silicium lors de la désoxydation.

On procède ensuite dans un réacteur de dépôt CVD ultrapropre, par exemple celui commercialisé par la Société Applied Materials sous la référence CENTURA HTF, à la réalisation de l'émetteur du transistor.

Plus précisément, on expose le bloc semiconducteur avec la base découverte au niveau de la fenêtre émetteur 800 à un mélange gazeux de silane et d'arsine, dans une atmosphère non oxydante, typiquement sous vide, ou sous hydrogène.

Les conditions du dépôt CVD sont par exemple un débit de 10 litres d'hydrogène/mn, un débit de 0,5 litres de silane/mn et un débit de 0,12 cm³ d'arsine/mn, à 630°C et sous une pression de 80 Torr.

L'homme du métier aura remarqué que ces conditions correspondent en fait à un dépôt polysilicium. Cependant, en raison du caractère chimiquement propre de la surface monocristalline de la base découverte au niveau de la fenêtre 800, le silicium déposé dans ce réacteur, épitaxie, c'est-à-dire qu'il croît monocristallin sur la base.

Après avoir obtenu une couche de silicium ayant une épaisseur de l'ordre de 2500 Å, on procède, de façon classique en utilisant un nouveau masque de photolithographie ainsi qu'un bloc correspondant de résine, à une gravure de la couche de silicium de façon à obtenir (figure 4) un émetteur 11 comportant dans la fenêtre 800 une partie inférieure 110 surmontée d'une partie supérieure 111 plus large que la fenêtre émetteur, la distance entre le bord de la fenêtre émetteur et le bord de la région 111 étant typiquement de l'ordre de 0,2 µ. Cet émetteur a donc été dopé in situ et il est monocristallin au moins au voisinage de l'interface avec la base dans la fenêtre émetteur.

On procède ensuite à un dépôt d'une couche de nitrure de silicium que l'on grave de façon à obtenir des espaceurs 120 incluant la couche 10 de nitrure de silicium s'appuyant sur les parois verticales de la région supérieure 111 de l'émetteur et sur la couche de dioxyde de silicium 9 (figure 5).

On définit ensuite à l'aide d'un nouveau masque, la géométrie de la base du transistor et l'on procède, après avoir préalablement gravé la couche d'oxyde 9, à une gravure de l'empilement des couches 8 en laissant subsister avantageusement la couche initiale 17 de nitrure de silicium de façon à obtenir la configuration illustrée sur la figure 5.

On dépose ensuite de part et d'autre de la base un bloc de résine, ainsi qu'une vignette de résine au-dessus de l'émetteur, puis on procède à une implantation P⁺ de l'empilement à l'aide de bore, de façon à définir la base extrinsèque Be (figure 6). On procède ensuite, après avoir protégé le transistor par de la résine, à une implantation d'arsenic, de façon à réaliser à la surface du puits collecteur une zone implantée N⁺ référencée 600.

L'étape finale consiste à réaliser les prises de connexion S de base d'émetteur et de collecteur par une technique connue du type "siliciure autoaligné" ("self aligned silicide") qui comporte le dépôt d'une couche de métal (par exemple du titane) pour former un siliciure (TiSi₂) sur les zones de silicium de la base extrinsèque, de l'émetteur et du collecteur extrinsèque.

Le fait d'avoir laisser subsister la couche de Si₃N₄ sur toute la plaquette lors de la gravure de l'empilement 8 présente un avantage considérable lors de la phase de siliciuration. En effet, dans une phase classique de siliciuration on dépose une couche protectrice de dioxyde de silicium ("Si protect" en langue anglaise), puis on grave cette couche de façon à ne laisser subsister du silicium qu'aux seuls endroits destinés à la formation de TiSi₂. On protège de ce fait d'autres zones de silicium de la plaquette qui ne doivent pas recevoir de titane à ce stade du traitement.

Cependant, lors de la gravure ultérieure de cette couche de protection qui s'effectue pendant une durée de gravure prédéterminée, on grave un peu de dioxyde de silicium sous-jacent, en particulier au niveau des zones d'isolement latéral.

Et, selon l'invention, la couche initiale 17 de Si₃N₄ sert d'arrêt pour la gravure de la couche de protection qui la recouvre et protège de ce fait notamment les régions d'isolement latéral.

Bien entendu, après siliciuration, la couche initiale 17 de Si₃N₄ est gravée avec arrêt sur l'oxyde des régions d'isolement latéral.

Un transistor selon l'invention, tel qu'illustré sur la figure 6, est donc un transistor bipolaire vertical n-p-n à base à hétérojonction silicium-germanium utilisable dans une technologie BiCMOS du type VLSI. La base repose en partie sur la couche initiale 17 de nitrure de silicium, et en partie sur la surface du collecteur intrinsèque située dans la fenêtre de base 170 ménagée dans la couche initiale 17 de nitrure de silicium. Il comporte en outre dans ce mode de réalisation un émetteur monocristallin, directement en contact avec le silicium de la base (par abus de langage car en fait l'émetteur est directement en contact avec la couche supérieure d'encapsulation 82 puisque, en raison de diffusion des dopants et de divers traitements thermiques, la jonction émetteur/base se situe dans la couche d'encapsulation 82). Il présente un bruit basse fréquence réduit, tout en conservant de bons paramètres statiques, notamment le gain en courant en raison de la présence de l'hétérojonction SiGe qui compense la perte de gain due à l'absence d'oxyde à l'interface entre emetteur et l'empilement 8. Il présente en outre une résistance d'émetteur réduite par rapport à des transistors à émetteur polycristallin.

Il est également particulièrement avantageux lors de la réalisation de l'émetteur dopé in situ de moduler la quantité de gaz dopant au fur et à mesure de l'épitaxie de l'émetteur. Ainsi, au début de l'épitaxie, on gardera par exemple le débit d'arsine mentionné ci-avant (0,12cm³/mn) tandis que dans la région supérieure de l'émetteur, on diminuera ce débit pour atteindre par exemple la valeur de 0,6 cm³/min. On obtiendra donc finalement, pour l'émetteur dopé in situ, une concentration de dopant As égale par exemple à 3 10²⁰/cm³ dans la région inférieure de l'émetteur au contact de la base et une concentration de dopant As égale par exemple à 10²⁰/cm³ dans la région supérieure de l'émetteur. Ces valeurs permettent d'obtenir donc à la fois une bonne injection d'électrons dans la partie inférieure de l'émetteur et une bonne siliciuration au-dessus de la partie supérieure de l'émetteur.

Ceci étant, l'invention n'est pas limitée à un transistor bipolaire vertical ayant un émetteur épitaxié. Elle s'applique de façon générale à tout type de transistor bipolaire vertical et en particulier également à ceux possédant un émetteur polycristallin, dans lesquels l'émetteur résulte d'un dépôt de polysilicium qui peut être effectué dans un four classique suivi d'un dopage ou bien être dopé in situ dans un réacteur de dépôt chimique en phase vapeur, et comportant, dans les deux cas, une couche d'oxyde présente à l'interface émetteur/base (émetteur/empilement 8).

L'invention s'applique également à tout type de base épitaxiée, en particulier, formée exclusivement de silicium pour laquelle l'empilement 8 se résume à une seule couche de silicium.

## Revendications

1. Procédé de réalisation d'une base à hétérojonction SiGe d'un transistor bipolaire vertical, comprenant la formation, sur un bloc semiconducteur comportant une région de collecteur intrinsèque (4) entourée dans sa partie supérieure par une région d'isolement latéral (5), d'une couche initiale (17) de nitrure de silicium ménageant une fenêtre (170) au-dessus de la surface du collecteur intrinsèque (4), puis une épitaxie non sélective d'un empilement (8) de couches de silicium et de silicium-germanium sur la surface du collecteur (4) située dans ladite fenêtre (170) et sur la couche initiale (17) de nitrure de silicium.

2. Procédé selon la revendication 1, caractérisé par le fait que l'étape de formation de la couche initiale (17) de nitrure de silicium ménageant ladite fenêtre (170) comporte une croissance d'une couche de dioxyde de silicium (6) sur ledit bloc semiconducteur, le dépôt de la couche initiale (17) de nitrure de silicium, une gravure de la couche de nitrure de silicium (17) avec arrêt sur la couche de dioxyde de silicium (6) de façon à définir ladite fenêtre, et une désoxydation chimique de la portion de couche de dioxyde de silicium présente dans la fenêtre.

3. Transistor bipolaire vertical comprenant une base à hétérojonction SiGe formée d'un empilement (8) de couches de silicium et de silicium-germanium reposant sur une couche initiale (17) de nitrure de silicium s'étendant sur une région d'isolement latéral (5) entourant la partie supérieure du collecteur intrinsèque (4), ainsi que sur la surface du collecteur intrinsèque (4) située à l'intérieur d'une fenêtre (170) ménagée dans la couche initiale de nitrure de silicium (17).
